## Europäisches Patentamt
## European Patent Office
## Office européen des brevets

(11) Veröffentlichungsnummer : **0 508 992 B1**

(12) **EUROPÄISCHE PATENTSCHRIFT**

(45) Veröffentlichungstag der Patentschrift :
**15.02.95 Patentblatt 95/07**

(51) Int. Cl.$^6$ : **G01N 22/00**

(21) Anmeldenummer : **91900676.7**

(22) Anmeldetag : **28.12.90**

(86) Internationale Anmeldenummer :
**PCT/AT90/00129**

(87) Internationale Veröffentlichungsnummer :
**WO 91/10899 25.07.91 Gazette 91/17**

(54) **VORRICHTUNG UND VERFAHREN ZUR BESTIMMUNG VON AMPLITUDEN- UND PHASENGRÖSSEN IN REFLEKTROMETRISCHEN MESSVERFAHREN.**

(30) Priorität : **29.12.89 AT 2974/89**

(43) Veröffentlichungstag der Anmeldung :
**21.10.92 Patentblatt 92/43**

(45) Bekanntmachung des Hinweises auf die
Patenterteilung :
**15.02.95 Patentblatt 95/07**

(84) Benannte Vertragsstaaten :
**AT BE CH DE DK ES FR GB GR IT LI LU NL SE**

(56) Entgegenhaltungen :
**WO-A-85/02266**
**DE-A- 2 601 238**
**US-A- 3 836 973**
**US-A- 4 052 666**

(56) Entgegenhaltungen :
**Conference Proceedings of the XVIII. European Microwave Conference,Rome,November 1987,M.A.Flemming et al.: "Microwave remote sensing techniques for measuring thin surface films",pages 590-595 see page 591, "Elipsometry";pages 592-593;figures 3-4 Conference Proceedings of the XVIII. European Microwave Conference Nürnberg,1983,J.Budin: " An automatic error correction method for measurement of antenna polarization",pages 845-850 see pages 845-846;page 847,to " IMPLEMENTED";PAGES 848-849," Calibration"**

(73) Patentinhaber : **PRITZL, Werner**
**Liechtensteinerstrasse 12**
**A-6800 Feldkirch (AT)**

(72) Erfinder : **PRITZL, Werner**
**Liechtensteinerstrasse 12**
**A-6800 Feldkirch (AT)**

(74) Vertreter : **Gibler, Ferdinand, Dipl.Ing. Dr. techn.**
**Dorotheergasse 7/14**
**A-1010 Wien (AT)**

EP 0 508 992 B1

**Beschreibung**

Die Erfindung bezieht sich auf eine Einrichtung zur Bestimmung von Amplituden- und Phasengrößen zweier unterschiedlich polarisierter von zwei getrennten Empfangsantennen aufgenommener, von mindestens einer Sendeantenne abgestrahlten und an einer zu untersuchenden Oberfläche reflektierte Signale, insbesondere Signale im Mikrowellenbereich, einer reflektometrischen Meßeinrichtung durch Messung der Amplituden der Eingangssignale und der Amplituden von Gemischen der Eingangssignale, sowie ein Verfahren zur Kalibrierung dieser Einrichtung und ein Meßverfahren mit dieser kalibrierten Einrichtung.

Die Reflektometrie ist ein bekanntes Meßverfahren zur Ermittlung der Brechzahl bzw. der Dielektrizitätskonstanten von Oberflächen bzw. in einer Erweiterung des Verfahrens zur Bestimmung von Brechzahl oder Dielektrizitätskonstanten und Schichtdicke einer eine Oberfläche bedeckenden Schicht. Bei diesem Verfahren werden durch elektromagnetische Wellen gebildete Signale, meist unter spitzem Winkel, auf die zu untersuchende Oberfläche gestrahlt und die reflektierte Welle, bzw. die reflektierten Signale mittels einer geeigneten Empfängeranordnung aufgenommen und die Beträge der p- und s-polarisierten Anteile der Signale und die Phasendifferenz zwischen den p- und den s- polarisierten Anteilen ermittelt.

Wie aus der US-A 4 052 666 bekannt, treten bei der Ermittlung der gesuchten Größen wie den Real- und Imaginärteil der Brech- bzw. Dielektrizitätszahl sowie Dicke der die Oberfläche bedeckenden Schichte, noch weitere Unbekannte auf. Dabei handelt es sich um das Reflexionsverhalten der Oberfläche beschreibende Größen, z.B. im Fall der US-A 4 052 666, daß sich unter der Oberfläche ein homogenes Dielektrikum befindet, um den Real- und Imaginärteil der Brech- bzw. Dielektrizitätszahl des Materials. In diesem Fall sind also fünf unbekannte Größen an der Messung beteiligt. Selbst wenn das empfangene Signal in zwei zueinander orthogonalen Richtungen polarisiert ist und nach Betrag und Phasendifferenz analysiert wird, verbleiben zumindest zwei aus den vorhandenen Daten nicht besstimmbare Größen, sodaß das gesamte Gleichungssystem unbestimmt bleibt, bzw. von bestimmten Annahmen ausgegangen werden muß, wodurch sich entsprechende Fehler ergeben können.

Besteht jedoch die Möglichkeit das Reflexionsverhalten der Oberfläche allein nach Betrag und Phasendifferenz zu bestimmen, so kann die komplexe Brech- bzw. Dielektrizitätszahl der Oberfläche, wie in der US-A 4 052 666 beschrieben, getrennt ermittelt werden. Mit der Kenntnis dieser Größen ist es in einer nachfolgenden Messung, bei Vorhandensein einer die Oberfläche bedeckenden Schicht möglich, auch die restlichen Unbekannten eindeutig zu bestimmen.

Begrenzt die Oberfläche jedoch ein inhomogenes Material, so kann das Reflexionsverhalten der Oberfläche nicht mehr durch die Komplexe Brech- bzw. Dielektrizitätszahl charakterisiert werden. In diesem allgemeinen, in der US-A 4 052 666 in keiner Weise behandelten Fall kann das Reflexionsverhalten einer elektromagnetischen Welle nur mehr durch zwei komplexe Reflexionsfaktoren, jeweils für den p- und den s- polarisierten Anteil der Welle beschrieben werden. Damit ergeben sich vier Unbekannte, die aus den drei Meßgrößen, u.zw. Amplitude des p- und des s- polarisierten Anteiles sowie die Phasendifferenz zwischen diesen Anteilen, nicht direkt bestimmt werden können. Die gleiche Schwierigkeit tritt auch auf, wenn die getrennte Ermittlung des Reflexionsverhaltens der Oberfläche nicht möglich ist.

Wenn z.B. Mikrowellenreflektometrie zur Bestimmung der Beschaffenheit und der Dicke von Verkehrsflächen bedeckende Schichten, wie Wasser, Salzlösungen, Eis, Schnee, usw. angewandt wird, wie dies aus der PCT/AT 84/00041 vorgeschlagen wird, so kann die Fahrbahn im allgemeinen nicht als homogenes Medium betrachtet werden. Es tritt daher die oben beschriebene Schwierigkeit bei der Bestimmung der gesuchten Größen, wie den Real- und den Imaginärteil der Brech- bzw. Dielektrizitätszahl und die Dicke der die Verkehrsfläche bedeckenden Schicht auf.

Bei einer aus der US-A 4 052 666 bekannten Einrichtung ist jede der beiden Empfangsantennen mit den Eingängen von Amplitudendetektoren verbunden, wobei die Eingänge der Amplitudendetektoren noch mit den Eingängen eines Phasendetektors verbunden sind. Die Ausgänge der beiden Amplitudendetektoren sind mit einem Dividierer verbunden, dessen Ausgang mit einem Rechner verbunden ist, der eingangsseitig auch mit dem Ausgang des Phasendetektors verbunden ist. In der US-A 4 052 666 sind jedoch keinerlei Angaben zur Realisierung der Amplitudendetektoren und vor allem nicht zur Realisierung eines Phasendetektors enthalten.

Weiters wurde durch die DE-A 26 01 238 eine Einrichtung vorgeschlagen, bei der die Signale einer Breitbandantenne über eine horizontale und eine vertikale Auskopplung zu gemeinsam betätigbare Umschalter geführt werden. Über einen Zweiwegeumschalter können dabei die vertikal oder die horizontal ausgekoppelten Signale wahlweise zu einer Schaltung zur vergleichenden Amplitudenmessung über einen weiteren Umschalter geführt werden. Über die erstgenannten gemeinsam betätigbaren Umschalter können die vertikal ausgekoppelten Signale über einen ein- und ausschaltbaren Phasenschieber und die horizontal ausgekoppelten Signale über einen Widerstand zu einer 180° Hybridschaltung geführt werden, die einen Summen- und einen Differenzausgang aufweist, wobei der letztere mit einem Widerstand abgeschlossen ist und der Summenwiderstand über einen Umschalter mit der Schaltung zur vergleichenden Amplitudenmessung verbindbar ist.

Bei dieser bekannten Einrichtung ergibt sich der Nachteil, daß die Messung der Amplituden und der Phasenlage der ausgekoppelten Signale nur nacheinander gemessen werden können, wodurch sich bei sich rasch ändernden zu erfassenden Parametern entsprechende Ungenauigkeiten ergeben. Außerdem leidet durch die Verwendung von Schaltern auch die Wiederholgenauigkeit der Messungen.

Ziel der Erfindung ist es, diese Nachteile zu vermeiden und eine Einrichtung der eingangs erwähnten Art vorzuschlagen, mit der die Bestimmung einer ausreichenden Anzahl von Meßgrößen möglich ist, um mit einem geeigneten Kalibrier- und Auswerteverfahren die Brech- bzw. Dielektrizitätszahl und die Schichtdicke auch bei einer sich rasch ändernden Beschaffenheit dieser Schichte mit hoher Wiederholgenauigkeit ermitteln zu können.

Erfindungsgemäß wird dies dadurch erreicht, daß die Empfangsantennen mit den Eingängen einer Leistungsteiler und Leistungsvereiniger aufweisenden Schaltung verbunden sind, deren vier Ausgänge mit Detektoren verbunden sind, von denen zwei mit den Signalen je einer zugeordneten Empfangsantenne direkt, und die beiden anderen mit einem Gemisch dieser Signale beaufschlagt sind, wobei einer dieser letzteren Detektoren mit einem Gemisch dieser Signale beaufschlagt ist, bei dem eines der beiden Signale in seiner Phase gedreht ist.

Durch diese Maßnahmen gelingt es die unterschiedliche Reflexion des p- und des s-polarisierten Anteils der das Signal bildenden elektromagnetischen Welle nach den folgenden Beziehungen

$$A = A_0 \cdot \sin(\omega t + \varphi)$$

und

$$B = B_0 \cdot \sin(\omega t)$$

den Beträgen A und B und der Phasendifferenz nach zu ermitteln.

An den Detektoren sind vier verschiedene Spannungen abgreifbar aus denen, wie noch an Hand der Figurenbeschreibung erläutert werden wird, unter Berücksichtigung von Kalibrierungskoeffizienten die Beträge der Reflexionsfaktoren für den p- und s-polarisierten Anteil der Welle und die Phasendifferenz zwischen dem p- und dem s-polarisierten Anteil der Welle, wie ebenfalls noch an Hand der Figurenbeschreibung erläutert werden wird, ermittelt werden können.

Nach einem weiteren Merkmal der Erfindung kann vorgesehen sein, daß die eingangsseitig mit den Empfangsantennen verbundenen Leistungsteiler mit ihren einen Ausgängen mit je einen Detektor verbunden sind und die zweiten Ausgänge dieser Leistungsteiler mit den Eingängen weiterer Leistungsteiler verbunden sind, deren eine Ausgänge mit einem Eingang je eines zugeordneten Leistungsvereinigers und jeder der zweiten Ausgänge der Leistungsteiler mit jenem Leistungsvereiniger verbunden ist, dessen anderer Eingang mit dem anderen Leistungsteiler verbunden ist, wobei in mindestens einer dieser Leitungen ein Phasenschieber angeordnet ist und die Ausgänge der Leistungsvereiniger mit Detektoren verbunden sind.

Auf diese Weise ergibt sich ein sehr einfacher Aufbau der erfindungsgemäßen Einrichtung.

Weiters kann vorgesehen sein, daß den Detektoren, die vorzugsweise durch Dioden gebildet sind, Abschwächer vorgeschaltet sind.

Durch diese Maßnahmen ist es möglich das den Detektoren zugeführte Signal auf Werte zu begrenzen, die in einem bestimmten Abschnitt der Kennlinie des Detektors liegen. Dadurch werden Fehler aufgrund von Abweichungen von einer angenommenen Kennlinie vermieden. So kann z.B. bei Detektoren mit einer in einem bestimmten Bereich praktisch quadratischen Kennlinie durch die vorgeschlagenen Maßnahmen sichergestellt werden, daß die an die Detektoren anliegenden Signale in diesem Bereich liegen.

Nach einem weiteren Merkmal der Erfindung kann vorgesehen sein, daß der zwischen dem einen Leistungsteiler und einem Leistungsvereiniger eingeschaltete Phasenschieber eine Phasenverschiebung von -90° bewirkt.

Durch diese Maßnahemen ergeben sich im Hinblick auf die Ermittlung der die Reflektion beschreibenden Daten besonders einfache Verhältnisse.

Ein weiteres Ziel der Erfindung ist es, ein Verfahren zur Kalibrierung der erfindungsgemäßen Einrichtung vorzuschlagen.

Erfindungsgemäß wird hiezu vorgeschlagen, daß in einem ersten Schritt die Empfangsantennen und die Sendeantenne(n) direkt aufeinander ausgerichtet werden, daß danach die Amplitudenwerte $A_0$ und $B_0$ - wie an sich bekannt - nach der folgenden Beziehung

$$A_0 = B_0 = \sqrt{\frac{D^2 + 4H^2}{D^2}}$$

errechnet werden, wobei D den Abstand zwischen den Antennen und H den Normalabstand der Empfangsantennen von der Oberfläche, deren Reflexion untersucht werden soll, bedeuten, und daß danach Messungen mit jeweils einem reflexionsfrei abgeschlossenen Eingang des im Betriebszustand mit den Antennen verbundenen Leistungsteilern sowie eine Messung, bei welcher an jedem der beiden Eingänge jeweils eine der beiden Antennen angeschlossen ist, durchgeführt werden.

Durch diese Normierung wird erreicht, daß bei der späteren Reflexionsmessung die Amplituden A und B direkt den Beträgen der Reflexionsfaktoren entsprechen.

Nun wird einer der im Betriebszustand mit einer Antenne verbundenen Eingänge reflexionsfrei abgeschlossen und damit eines der Eingangssignale, z.B. B, gleich 0 gesetzt, um durch eine Messung der Spannungen an den vier Ausgängen mit Detektordioden die Aufteilung des anderen Signals, in diesem Fall A, auf die vier Ausgänge zu bestimmen.

Durch reflexionsfreien Abschluß des anderen Eingangs und wieder Verbinden des ersten Eingangs mit der Antenne kann in einem weiteren Schritt die Aufteilung des anderen Signals auf die vier Ausgänge bestimmt werden.

In einem letzten Schritt der Kalibrierung, bei dem die Antennen immer noch direkt aufeinander ausgerichtet sind, werden wieder beide Eingänge mit den jeweiligen Antennen verbunden. Da in diesem Fall keine Reflexion stattfindet, beträgt auch die Phasenverschiebung $\varphi = 0$ und es können sämtliche Phasenverschiebungen innerhalb der Empfangserhaltung ermittelt werden.

In Weiterbildung dieses Verfahrens kann erfindungsgemäß noch so vorgegangen werden, daß sowohl für den p -, als auch für den s - polarisierten Anteil der Welle die Antennen (4), (5) und (6) in ihre endgültige Ausrichtung gebracht werden und die Beträge der s- und p- polarisierten Anteile der Welle und die Phasendifferenz zwischen den s- und p- polarisierten Anteilen der von der unbedeckten Oberfläche reflektierten Wellen und danach die Beträge der s- und p- polarisierten Anteile der Welle und die Phasendifferenz zwischen den s- und p- polarisierten Anteilen der von einer mit einer Schicht mit bekannter Brech- bzw. Dielektrizitätszahl, vorzugsweise Regenwasser, bedeckten Oberfläche reflektierten Wellen gemessen werden, wobei aus diesen Meßwerten Betrag und Phase der Reflexionsfaktoren der unbedeckten Oberfläche, z.B. einer trockenen Fahrbahn, ermittelt wird. Hiedurch liegen alle Festparameter vor, welche nachfölgenden laufenden Messungen (Betriebszustand) dienen.

Ferner ist Gegenstand der Erfindung, ein Meßverfahren, durchgeführt mit der nach dem vorstehenden Verfahren kalibrierten, erfindungsgemäßen Einrichtung, das erfindungsgemäß darin besteht, daß die Beträge der s- und p-polarisierten Anteile der Welle und die Phasendifferenz zwischen den s- und p- polarisierten Anteilen mit Bezug auf die mit einer Schicht bedeckten Oberfläche gemessen und aus diesen Meßwerten unter Berücksichtigung der komplexen Reflexionsfaktoren der unbedeckten Oberfläche sowohl Real- und Imaginärteil der Brech- bzw. Dielektrizitätszahl als auch die Dicke der Schicht ermittelt werden. Hiedurch ist z.B. eine laufende Messung in besonders einfacher insbesondere vollständig automatisierter Weise möglich.

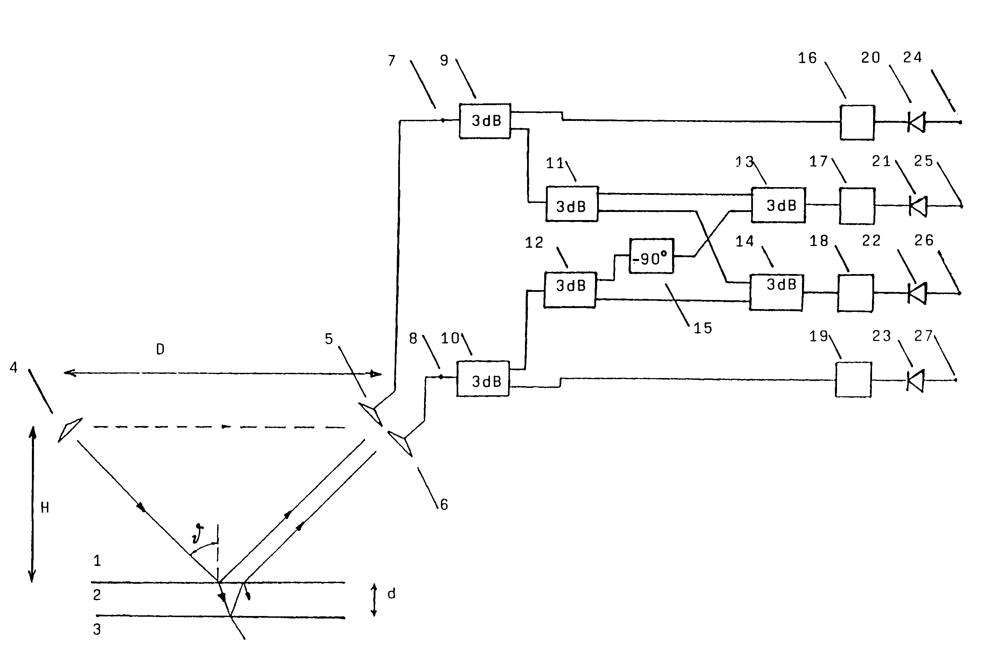

Die Erfindung wird nun anhand der Zeichnung näher erläutert, die ein Ausführungsbeispiel einer erfindungsgemäßem Einrichtung zeigt.

Die Eingänge 7 und 8 der beiden Leistungsteiler 9 und 10 sind mit den beiden othogonal zueinander polarisierten Empfangsantennen 5 und 6 verbunden, die von der Sendeantenne 4 abgestrahlte und an der zu untersuchenden Oberfläche reflektierte Signal, die in Form von Mikrowellen vorliegen, empfangen, wobei die Reflexion der Signale an der Grenzfläche zwischen den Medien 1 und 2 und auch nach Durchdringung der Schichte 2 an der Oberfläche des Mediums 3 erfolgt. Dabei kommt es beim Eintreten der Signale in die Schichte 2 zu einer Brechung. Dadurch trifft das an der Oberfläche des Mediums 2 reflektierte Signal und das an der Oberfläche des Mediums 3 reflektierte Signal zu verschiedenen Zeiten bei den beiden Empfangsantennen 5 und 6 ein.

Die an den Empfangseingängen 7 und 8 anliegenden Signale A und B entsprechen dabei den folgenden Beziehungen:

$$A = A_O \cdot \sin(\omega t + \varphi_{OA} + \varphi)$$

und

$$B = B_O \cdot \cos(\omega t + \varphi_{OB})$$

Die Amplituden $A_O$ und $B_O$ charakterisieren dabei die unterschiedliche Reflexion des p- und s-polarisierten Anteil der elektromagnetischen Welle, die von der Sendeantenne 4 ausgesandt wurde, dem Betrage nach, während der Winkel $\varphi$ die Phasendifferenz zwischen p- und s-polarisiertem Anteil angibt. Die Winkel $_{OA}$ und $_{OB}$ geben die jeweiligen Phasenverschiebungen auf dem Weg der Signale von den Empfangsantenhen 5 bzw. 6 bis zu den Eingängen 7 bzw. 8 der Leistungsteiler und Leistungsvereiniger aufweisende Schaltung an.

Diese Schaltung weist sechs Leistungsteiler, vorzugsweise 3-dB Leistungsteiler bzw. Leistungsvereiniger 9 bis 14, sowie einen Phasenschieber 15 auf.

Dabei stehen die einen Ausgänge der Leistungsteiler 9 und 10 direkt mit den Ausgängen 24 und 27 in Verbindung. Die zweiten Ausgänge der Leistungsteiler 9, 10 sind mit weiteren Leistungsteilern 11 und 12 verbunden. Die einen Ausgänge der Leistungsteiler 11 und 12 sind mit einem Eingang je eines Leistungsvereinigers 13, 14 verbunden. Der zweite Ausgang des Leistungsteilers 11 ist dabei mit dem Leistungsvereiniger 14 verbunden, dessen anderer Eingang mit dem Leistungsteiler 12 verbunden ist. Der Leistungsteiler 12 ist über einen Phasenschieber 15 mit dem Leistungsvereiniger 13 verbunden, dessen anderer Eingang mit dem Leistungsteiler 11 verbunden ist.

Weiters sind vier Mikrowellen-Detektordioden 20 bis 27 vorgesehen, die gleichgerichtete HF-Signale an die Ausgänge 24 bis 27 liefern, wobei jedoch Abschwächer 16 bis 19 den Detektordioden 20 bis 27 vorgeschaltet sind.

Die Abschwächer sind dabei so dimensioniert, daß die Detektordioden 20 bis 23 im quadratischen Bereich ihrer Kennlinie betrieben werden können. Am Ausgang 24 und 27 werden, quadratische Kennlinien der Detektordioden 20 bis 23 vorausgesetzt, Spannungen X, T auftreten, die proportional $A_O^2$ und $B_O^2$ proportional sind, wobei

$$X = k_{AX} \cdot A_O^2$$

und

$$T = k_{BT} \cdot B_O^2$$

entspricht. Dabei bedeuten $k_{AX}$ und $k_{BT}$ Kalibrierungskoeffizienten.

Die Ausgangsspannungen an den Ausgängen Y und Z betragen, wieder quadratische Kennlinien der Detektordioden 21 und 22 vorausgesetzt,

$$Y = k_{AY}^2 A_O^2 + k_{BY}^2 B_O^2 + 2 k_{AY} k_{BY} A_O B_O \cos (\varphi + (\varphi_{AO} - \varphi_{BO}) + (\varphi_{AY} - \varphi_{BY}))$$

und

$$Z = k_{AZ}^2 A_O^2 + k_{BZ}^2 B_O^2 + 2 k_{AZ} k_{BZ} A_O B_O \cos (\varphi + (\varphi_{AO} - \varphi_{BO}) + (\varphi_{AZ} - \varphi_{BZ}))$$

wobei die Phasendiffernz zwischen dem Eingang 7 und den Detektordioden 21 und 22 mit $\varphi_{AY}$ und $\varphi_{AZ}$ und die Phasendifferenz zwischen dem Eingang 8 und den Detektordioden 21 und 22 mit $\varphi_{BY}$ und $\varphi_{BZ}$ bezeichnet sind.

Berücksichtigt man nun, daß abgesehen von Fertigungstoleranzen $\varphi_{AY}$, $\varphi_{AZ}$ und $\varphi_{BZ}$ gleich groß sind und der Phasenschieber 15 eine Phasenverschiebung von -90° bewirkt und somit gibt

$$\varphi_{BX} \approx \varphi_{BZ} - 90°$$

kann man schreiben

$$(\varphi_{AZ} - \varphi_{BZ}) - (\varphi_{AY} - \varphi_{BY}) = -90° + \varepsilon$$

wobei $\varepsilon$ einen kleinen Winkel beschreibt, der sämtliche der erwähnten Fertigungstoleranzen des Leistungsteilers 9 bis 14, der Abschwächer 16 bis 19 und des Phasenschiebers 15 umfaßt.

Führt man weiters die Bezeichnung

$$\Delta\varphi = (\varphi_{AO} - \varphi_{BO}) + (\varphi_{AY} - \varphi_{BY})$$

ein, so ergeben sich für die Ausgangsspannungen Y und Z an den Ausgängen 25 und 26 die einfacheren Beziehungen

$$Y = k_{AY}^2 A_O^2 + k_{BY}^2 B_O^2 + 2 k_{AY} k_{BY} A_O B_O \cos(\varphi + \Delta\varphi)$$

und

$$Z = k_{AZ}^2 A_O^2 + k_{BZ}^2 B_O^2 + 2 k_{AZ} k_{BZ} A_O B_O \sin(\varphi + \Delta\varphi + \varepsilon)$$

wobei wieder vorausgesetzt ist, daß die Detektordioden 21 und 22 im quadratischen Bereich der Kennlinie betrieben werden.

Bei dem aus der Zeichnung ersichtlichen Empfängernetzwerkes stehen an dessen Ausgängen 24 bis 27 elektrische Spannungen X, Y, Z und T zur Verfügung, mit deren Hilfe die eindeutige Bestimmung der Amplituden $A_O$ und $B_O$ sowie der Phasendifferenz $\varphi$ möglich ist, sofern die Kalirierungskoeffizienten $k_{AX}$, $k_{AY}$, $k_{BY}$, $k_{AZ}$, $k_{BZ}$, $k_{BT}$, $\Delta\varphi$ und $\varepsilon$ bekannt sind.

Mit Hilfe eines erfindungsgemäßen Verfahrens zur Kalibrierung der in der Zeichnung dargestellten Einrichtung und Bestimmung der drei Meßgrößen u.zw. den Betrag des p- und des s-polarisierten Anteils und Phasendifferenz sowie die Phasendiffernz zwischen p- und s-polarisierten Anteil und in einem weiteren Schritt die eindeutige Bestimmung der gesuchten Größen, wie komplexe Brech- bzw. Dielektrizitätszahl und die Dicke der Schicht möglich ist.

Zur Durchführung des erfindungsgemäßen Kalibrierungsverfahrens werden die Sendeantenne 4 und die beiden Empfangsantennen 5 und 6 direkt aufeinander ausgerichtet, sodaß die ausgesandten Signale in Form von elektromagnetischen Wellen, direkt auf die Empfangsantennen 5 und 6 auftreffen. Bei der Kalibrierung werden den Amplituden $A_O$ und $B_O$ die folgenden Werte zugewiesen:

$$A_O = B_O = \sqrt{\frac{D^2 + 4H^2}{D^2}}$$

Dadurch entsprechen bei einer späteren Reflexionsmessung $A_O$ und $B_O$ direkt den Beträgen der Reflexionsfaktoren. Der Abstand zwischen den Empfangsantennen ist dabei mit D, der Normalabstand der Antennen von der Oberfläche des Mediums 2 mit H bezeichnet.

Betragen beispielsweise D = 10m und H = 4m, so muß den Amplituden der Wert 1.2806 zugewiesen werden.

Als erstes wird die Empfangsantenne 5 mit dem Eingang 7 der Leistungsteiler und Leistungsvereiniger aufweisenden Schaltung verbunden und der zweite Eingang 8 reflexionsfrei abgeschlossen. Da dadurch das Signal B = 0 ist, ergeben sich aus dieser Messung die Kalibrierkoeffizienten $k_{AX}$, $k_{AY}$ und $k_{AZ}$ :

$$X = k_{AX} \cdot A_O^2 \qquad k_{AX} = \frac{X}{A_O^2} = X \frac{D^2}{D^2 + 4H^2}$$

$$Y = k_{AY}^2 \cdot A_O^2 \qquad k_{AY} = \sqrt{\frac{Y}{A_O^2}} = \sqrt{\frac{D^2}{D^2 + 4H^2}}$$

$$Z = k_{AZ}^2 \cdot A_O^2 \qquad k_{AZ} \sqrt{\frac{Z}{A_O^2}} = \sqrt{Z}\sqrt{\frac{D^2}{D^2 + 4H^2}}$$

$$T = 0$$

Betragen die Spannungen beispielsweise X = 1.05 mV, Y = 0.24 mV und Z = 0.27 mV, so ergeben sich für Kalibrierungskoeffizienten

$$k_{AX,} = 0.6402 \text{ mV}, k_{AY} = 0.3825 \sqrt{\text{mV}} \text{ und } k_{AZ} = 0.4058 \sqrt{\text{mV}}.$$

Wird umgekehrt der Eingang 7 reflexionsfrei abgeschlossen und die Empfangsantenne 6 mit dem Eingang 8 verbunden, so können analog die Kalibrierungskoeffizienten $k_{BY}$, $k_{BZ}$ und $k_{BT}$ ermittelt werden.

$$X = 0$$

$$Y = k_{BY}^2 B_O^2 \Rightarrow k_{BY} = \sqrt{\frac{Y}{B_O^2}} = \sqrt{Y}\sqrt{\frac{D^2}{D^2 + 4H^2}}$$

$$Z = k_{BZ}^2 B_O^2 \Rightarrow k_{BZ} = \sqrt{\frac{Z}{B_O^2}} = \sqrt{Z}\sqrt{\frac{D^2}{D^2 + 4H^2}}$$

$$T = k_{BT} B_O^2 \Rightarrow k_{BY} = \frac{T}{B_O^2} = T \frac{D^2}{D^2 + 4H^2}$$

Betragen die Spannungen beispielsweise Y = 0.25 mV, Z = 0.26 mV und T = 0.95 mV, so ergeben sich die Kalibrierkoeffizienten

$$k_{BY} = 0.3904 \sqrt{\text{mV}}, k_{BZ} = 0.3982 \sqrt{\text{mV}} \text{ und } k_{BT} = 0.5793 \text{ mV}.$$

In einem dritten Schritt wird die Empfangsantenne 5 mit dem Eingang 7 der Leistungsteiler und Leistungsvereiniger aufweisenden Schaltung und die Empfangsantenne 6 mit dem Ein-gang 8 verbunden. Aus dieser Messung ergeben sich die noch verbleibenden unbekannten Kalibrierungskoeffizienten $\Delta\varphi$ und $\varepsilon$, da in diesem Fally $\varphi$ = 0 gilt:

$$Y = k_{AY}^2 A_O^2 + k_{BY} B_O^2 + 2 k_{AY} k_{BY} A_O B_O \cos(A\varphi),$$

$$A_O = B_O = \sqrt{\frac{D^2 + 4H^2}{D^2}} \Rightarrow \cos\Delta\varphi = \frac{Y - k_{AY}^2 A_O^2 - k_{BY}^2 B_O^2}{2 k_{AY} k_{BY} A_O B_O}$$

$$Z = k_{AZ}^2 A_O^2 + k_{BZ}^2 B_O^2 + 2 k_{AZ} k_{BZ} A_O B_O \sin(\Delta\varphi + \varepsilon),$$

$$A_O = B_O = \sqrt{\frac{D^2 + 4H^2}{D^2}} \Rightarrow \sin(\Delta\varphi + \varepsilon) = \frac{Z - k_{AZ}^2 A_O^2 - k_{BZ}^2 B_O^2}{2 k_{AZ} k_{BZ} A_O B_O}$$

und daraus $\Delta\varphi$ und $\varepsilon$ ermittelt werden können.

Betragen die Spannungen beispielsweise Y = 0.18 mV und Z = 0.92 mV, so ergeben sich cos($\Delta\varphi$) = - 0.6327 und sin ($\Delta\varphi + \varepsilon$) = 0.7356. Aus cos ($\delta\varphi$) = - 0.6327 folgt nun, daß = 129,25° oder -129,25° sein kann. Da aber sin ($\Delta\varphi + \varepsilon$) » 0, kommt nur $\delta\varphi$ = 129,25° als Lösung in Frage. Analog folgt aus sin ($\Delta\varphi + \varepsilon$) = 0.7356 und cos ($\Delta\varphi$) « 0, daß $\Delta\varphi + \varepsilon$ = 132,64° und damit $\varepsilon$ = 132,64° -$\Delta\varphi$ = 3.39°.

Durch diese Kalibrierungsvorschrift werden nun sämtliche Kalibrierungskoeffizienten der erfindungsgemäßen Einrichtung ermittelt und damit ist nach dem Ausrichten der Antennen 4 bis 6 auf die zu messende Oberfläche, z.B. eine Fahrbahn, die Messung der Amplitude des p- und s-polarisierten Anteiles des ausgesandten Signales und der Phasendifferenz zwischen p- und s-polarisiertem Anteil möglich.

Für die Berechnung der Größen $A_O$, $B_O$ und $\varphi$ aus den gemessenen Spannungen wird dabei folgendermaßen vorgegangen: Zuerst werden die Amplituden $A_O$, und $B_O$ aus den Ausgangsspannungen X und T ermittelt:

$$X = k_{AX} A_O^2 \qquad A_O = \sqrt{\frac{X}{k_{AX}}}$$

$$T = k_{BT} B_O^2 \qquad B_O = \sqrt{\frac{T}{k_{BT}}}$$

Damit können aus den Ausgangsspannungen Y und Z

$$\cos(\varphi + \Delta\varphi) = \frac{Y - k_{AY}^2 A_O^2 - k_{BY} B_O^2}{2 k_{AY} k_{BY} A_O B_O}$$

$$\sin(\varphi + \Delta\varphi + \varepsilon) = \frac{Z - k_{AZ}^2 A_O^2 - k_{BZ}^2 B_O^2}{2 k_{AZ} k_{BZ} A_O B_O}$$

berechnet werden. Mit der Beziehung

$$\sin(\varphi + \Delta\varphi + \varepsilon) = \sin(\varphi + \Delta\varphi) \cdot \cos\varepsilon + \cos(\varphi + \Delta\varphi) \cdot \sin\varepsilon$$

$$\sin(\varphi + \Delta\varphi) = \frac{\sin(\varphi + \Delta\varphi + \varepsilon) - \cos(\varphi + \Delta\varphi) \cdot \sin\varepsilon}{\cos\varepsilon}$$

enhält man

$$\tan(\varphi + \Delta\varphi) = D\frac{\sin(\varphi + \Delta\varphi)}{\cos(\varphi + \Delta\varphi)} = \frac{1}{\cos\varepsilon}\frac{\sin(\varphi + \Delta\varphi + \varepsilon)}{\cos(\varphi + \Delta\varphi)} - \tan\varepsilon$$

Aus $\tan(\varphi + \Delta\varphi)$ und $\cos(\varphi + \Delta\delta)$ kann $\varphi + \Delta\varphi$ und damit $\varphi$ eindeutig bestimmt werden.

Betragen beispielsweise die Ausgangsspannungen X = 0.0250 mV, Y = 0.0696 mV, Z = 0.0634 mV und T = 0.1450 mV so ergeben sich $A_o$ = 0.1976 und $B_o$ = 0.5003. Weiters erhält man $\cos(\varphi + \Delta\varphi)$ = 0.8718 und $\sin(\varphi + \Delta\varphi + \varepsilon)$ = 0.5409 und damit $\tan(\varphi + \Delta\varphi)$ = 0.5623. Da $\cos(\varphi + \Delta\varphi) > 0$ ergibt sich aus $\tan(\varphi + \Delta\varphi)$ = 0.6095 für $\varphi + \Delta\varphi$ = 29,34° und für $\varphi$ = 99,9°.

Ein weiteres Ziel ist die Bestimmung der Reflexionsfaktoren der unbedeckten Oberfläche des Mediums 3, beispielsweise der trockenen Fahrbahn, nach Betrag und Phase, was erlaubt, aus der Messung der Beträge der s- und p- Polarisation und dder Phasendifferenz zwischen s- und p- Polarisation der mit einer Schicht bedeckten Oberfläche die Brechbzw. Dielektrizitätszahl der Schicht und die Schichtdicke zu bestimmen.

Wie bereits erläutert, ist es für die Bestimmung der gesuchten Größen, wie Brech- und Dielektrizitätszahl und Dicke der Schichte, unbedingt erforderlich, die Reflexionseigenschaften der Oberfläche zu kennen. Für den Gesamtreflexionsfaktor sowohl für den p- als auch für den s-polarisierten Anteil der Werte gilt folgende, bereits aus der US-PS 4 052 666 bekannte Formel:

$$\underline{R} = \frac{\underline{r}_{12} + \underline{r}_{23}\,e^{-2j\Phi}}{1 + \underline{r}_{12}\,\underline{r}_{23}{}^{-2k\Phi}}$$

wobei für $\underline{r}_{12}$ der Reflexionsfaktor zwischen dem sich oberhalb der Oberfläche 1 befindlichem Medium und dem Medium der Schicht 2 und für $\underline{r}_{23}$ der Reflektionsfaktor zwischen dem Medium der Schicht 2 und dem Medium 3 der entsprechenden Polarisationsrichtung eingesetzt werden. Der Reflexionsfaktor $\underline{r}_{12}$ kann in bekannter Weise unter Einsatz der Fresnel'schen Formel ermittelt werden. Die aus der Literatur bekannte Größe

$$\underline{\Phi} = \frac{2\pi}{o} \cdot d \cdot \sqrt{\underline{\varepsilon}_{r2} - \underline{\varepsilon}_{r1} \cdot \sin^2(\text{fon}128d)}$$

beschreibt die Phasenverschiebung beim einmaligen Durchlaufen der Schicht, wobei $\lambda_o$ die freie Wellenlänge, d die Dicke der Schicht und $\underline{\varepsilon}_{r1}$ die komplexe Dielektrizitätszahl für das Medium oberhalb der Oberfläche 1, wobei im Falle von Luft für diesen Wert ein Wert von 1 als guter Näherungswert gilt, und $\underline{\varepsilon}_{r2}$ die komplexe Dielektrizitätszahl für das Medium der Schicht 2 bedeuten.

Durch das im folgenden beschriebene Auswerteverfahren können der Real- und der Imaginäranteil der komplexen Größen $\underline{r}_{23}$ für die beiden Polarisationsrichtungen p und s bestimmt und somit die gesuchten Größen, wie die komplexen Brech- bzw. Dielektrizitätszahl und die Dicke der Schicht 2 ermittelt werden.

Die Gleichung für die Berechnung des Gesamtreflexionsfaktors $\underline{R}$ gilt für alle Schichtdicken, also auch für die Dicke d = 0, woraus sich folgende Beziehung ergibt:

$$\underline{r}_{23} = \frac{\underline{r}_{13} - \underline{r}_{12}}{1 - \underline{r}_{12}\underline{r}_{13}}$$

Der komplexe Reflexionsfaktor $\underline{r}_{23}$ läßt sich überraschenderweise aus dem komplexen Reflexionsfaktor $\underline{r}_{13}$ zwischen dem Medium oberhalb der Oberfläche 1 und dem Medium 3, jeweils wieder für beide Polarisationsrichtungen, ermitteln.

Somit muß für die Lösung der gesamten Aufgabe nur noch die Reflexionsfaktoren zwischen dem Medium 1 und dem Medium 3 bekannt sein.

Drei Bedingungen für diese vier unbekannten Größen Real- und Imaginärteil des Reflexionsfaktor $\underline{r}_{13}$ sowohl für den p- als auch für den s-polarisierten Anteil des Signales bzw. der elektromagnetischen Welle, lassen sich durch einmalige Messung der unbedeckten Oberfläche (Schichtdicke d = 0) mittels der erfindungsgemäßen Einrichtung ermitteln.

Wird beispielsweise die Antenne 5 für die p - polarisierte Welle und die Antenne 6 für die s - polarisierte Welle eingesetzt, so gilt bei d = 0:

$$|\underline{r}_{13}, p| = A_o$$
$$|\underline{r}_{13}, s| = B_o$$

$\arg(\underline{r}_{13}, p) - \arg(\underline{r}_{13}, s) = \varphi$ bzw. $\arg(\underline{r}_{13}, p) = \arg(\underline{r}_{13}, s) + \varphi$.

Somit bleibt noch eine Größe, beispielsweise $\arg(\underline{r}_{13,s})$ unbestimmt.

Es ist noch eine weitere Messung notwendig, um das gesamte Gleichungssystem lösen und damit die gesuchten Größen, wie komplexe Brech- und Dielektrizitätszahl und Dicke der Schicht, bestimmen zu können. Dies geschieht bei der Auswertung durch eine weitere, nur einmal durchzuführende Messung, bei der die Oberfläche von einer Schicht bedeckt ist, von der zumindest eine der Größen, wie Real- oder Imaginärteil der Brechbzw. Dielektrizitätszahl oder die Schichtdicke bekannt ist. Dabei werden wieder drei Größen gemessen, wobei höchstens zwei weitere Unbekannte auftreten, sodap das gesamte Gleichungssystem lösbar ist. Im konkreten Fall der Messung von einer eine Verkehrsfläche bedeckenden Schicht ist kein künstliches Aufbringen einer Schicht und damit eine Sperre der Verkehrsfläche für den Verkehr erforderlich. Es genügt, die Messung während eines Regens durchzuführen, da die komplexe Brech- bzw. Dielektrizitätszahl von Wasser bekannt ist, wobei lediglich vorausgesetzt werden muß, daß nicht Salz gestreut ist. Aufgrund der Sensivität des Gleichungssystems sollte diese Messung bei einer geringen Schichtdicke d $<< \lambda/4$ durchgeführt werden.

Wird die oben erwähnte weitere Messung mit einer Schicht durchgeführt, von der die komplexe Brech- bzw. Dielektrizitätszahl bekannt ist, wie bei Wasser auf einer Fahrbahn, müssen nur zwei Größen gemessen und bei der Berechnung berücksichtigt werden.

In der Reflektometrie ist es üblich, vor allem den Quotienten vom Gesamtreflexionsfaktor für die p - Polarisation $\underline{R}_p$ und für die s - Polarisation $\underline{R}s$ für die Auswertungen zu verwenden. Damit ergibt sich für den hier beschriebenen Fall, daß nämlich arg $(\underline{r}_{13,s})$ und die Schichtdicke d unbekannt sind, folgendes Gleichungssystem:

$$\mathrm{Re}\left\{\begin{array}{c} R_p \\ -- \\ R_s \end{array}\right\} \quad = \quad f\ (arg(\underline{r}_{13},\ s)\ ,\ d) \ = \ \frac{A_0}{B_0}\ \cos\varphi$$

$$\mathrm{Im}\left\{\begin{array}{c} R_p \\ -- \\ R_s \end{array}\right\} \quad = \quad g\ (arg(\underline{r}_{13},\ s)\ ,\ d) \ = \ \frac{A_0}{B_0}\ \sin\varphi$$

Die gemessenen Größen sind darin $A_0$ , $B_0$ und $\varphi$ ; f und g symbolisieren, daß Real- und Imaginärteil des Quotienten der Gesamtreflexionsfaktoren nur noch von arg $(\underline{r}_{13,s})$ und d abhängen. Dieses Gleichungssystem ist so kompliziert, daß es nur noch numerisch nach arg $(\underline{r}_{13,s})$ und d aufgelöst werden kann.

Die Vorteile der erfindungsgemäßen Einrichtung einschließlich des Kalibrier- und Auswerteverfahrens gegenüber einem bekannten Empfänger mit Überlagerungsempfang und damit verbundenen einem oder mehreren lokalen Oszillatoren, liegen darin, daß die erfindungsgemäße Einrichtung einen wesentlich geringeren Schaltungsaufwand erfordert. Da die beiden Eingangssignale, die ja von der selben Quelle kommen, miteinander gemischt werden, ist diese Schaltung auch weitgehend unempfindlich gegenüber kleinen Schwankungen der Frequenz der Eingangssignale. Wird der Sender amplitudenmoduliert, können sämtliche Vorteile der bekannten Synchrondetektion ausgenützt werden. Für die Kalibrierung ist nur ein einmaliges Ausrichten der Antennen aufeinander und die Durchführung der oben beschriebenen Messungen notwendig. Die Bestimmung des Reflexionsverhaltens der Oberfläche kann im konkreten Fall der Bestimmung von Schichten auf Verkehrsflächen im laufenden Betrieb erfolgen, wodurch Sörungen im Verkehrsfluß minimiert und die Sperre von Verkehrsflächen vermieden wird.

## Patentansprüche

1. Einrichtung zur Bestimmung von Amplituden- und Phasengrößen zweier unterschiedlich polarisierter von zwei getrennten Empfangsantennen aufgenommener, von mindestens einer Sendeantenne abgestrahlten und an einer zu untersuchenden Oberfläche reflektierte Signale, insbesondere Signale im Mikrowellenbereich, einer reflektometrischen Meßeinrichtung durch Messung der Amplituden der Eingangssignale und der Amplituden von Gemischen der Eingangssignale, **dadurch gekennzeichnet,** daß die Empfangsantennen (5, 6) mit den Eingängen einer Leistungsteiler (9, 10, 11, 12) und Leistungsvereiniger (13, 14) aufweisenden Schaltung verbunden sind, deren vier Ausgänge mit Detektoren (20, 21, 22, 23) verbunden sind, von denen zwei mit den Signalen je einer zugeordneten Empfangsantenne (5, 6) direkt, und die beiden anderen mit einem Gemisch dieser Signale beaufschlagt sind, wobei einer dieser letzteren Detektoren (21, 22) mit einem Gemisch dieser Signale beaufschlagt ist, bei dem eines der beiden Signale in seiner Phase gedreht ist.

2. Einrichtung nach Anspruch 1, dadurch gekennzeichnet, daß die eingangsseitig mit den Empfangsantennen (5, 6) verbundenen Leistungsteiler (9, 10) mit ihren einen Ausgängen mit je einem Detektor (20, 23) verbunden sind und die zweiten Ausgänge dieser Leistungsteiler (9, 10) mit den Eingängen weiterer Leistungsteiler (11, 12) verbunden sind, deren eine Ausgänge mit einem Eingang je eines zugeordneten Leistungsvereinigers (13, 14) und jeder der zweiten Ausgänge der Leistungsteiler (11, 12) mit jenem Leistungsvereiniger (13, 14) verbunden ist, dessen anderer Eingang mit dem anderen Leistungsteiler (11,

12) verbunden ist, wobei in mindestens einer dieser Leitungen ein Phasenschieber (15) angeordnet ist und die Ausgänge der Leistungsvereiniger (13, 14) mit Detektoren (21, 22) verbunden sind.

3. Einrichtung nach Anspruch 1 oder 2, dadurch gekennzeichnet, daß den Detektoren (20, 21, 22, 23), die vorzugsweise durch Dioden gebildet sind, Abschwächer (16, 17, 18, 19) vorgeschaltet sind.

4. Einrichtung nach einem der Ansprüche 1 bis 3, dadurch gekennzeichnet, daß der zwischen dem Leistungsteiler (12) und dem Leistungsvereiniger (13) eingeschaltete Phasenschieber (15) eine Phasenverschiebung von -90° bewirkt.

5. Verfahren zur Kalibrierung einer Einrichtung zur Bestimmung von Amplituden- und Phasengrößen zweier unterschiedlich polarisierter von zwei getrennten Empfangsantennen aufgenommener, von mindestens einer Sendeantenne abgestrahlten und an einer zu untersuchenden Oberfläche reflektierte Signale, insbesondere Signale im Mikrowellenbereich, einer reflektometrischen Meßeinrichtung durch Messung der Amplituden der Eingangssignale und der Amplituden von Gemischen der Eingangssignale, **dadurch gekennzeichnet**, daß in einem ersten Schritt die Empfangsantennen und die Sendeantenne(n) direkt aufeinander ausgerichtet werden, daß danach die Amplitudenwerte $A_0$ und $B_0$ - wie an sich bekannt - nach der folgenden Beziehung

$$A_0 = B_0 = \sqrt{\frac{D^2 + 4H^2}{D^2}}$$

errechnet werden, wobei D den Abstand zwischen den Antennen und H den Normalabstand der Empfangsantennen von der Oberfläche, deren Reflexion untersucht werden soll, bedeuten, und daß danach Messungen mit jeweils einem reflexionsfrei abgeschlossenen Eingang des im Betriebszustand mit den Antennen verbundenen Leistungsteilern sowie eine Messung, bei welcher an jedem der beiden Eingänge jeweils eine der beiden Antennen angeschlossen ist, durchgeführt werden.

6. Verfahren nach Anspruch 5, dadurch gekennzeichnet, daß sowohl für den p-, als auch für den s- polarisierten Anteil der Welle die Antennen (4), (5) und (6) in ihre endgültige Ausrichtung gebracht werden und die Beträge der s- und p- polarisierten Anteile der Welle und die Phasendifferenz zwischen den s- und p- polarisierten Anteilen der von der unbedeckten Oberfläche reflektierten Wellen und danach die Beträge der s- und p-polarisierten Anteile der Welle und die Phasendifferenz zwischen den s- und p- polarisierten Anteilen der von einer mit einer Schicht mit bekannter Brech- bzw. Dielektrizitätszahl, vorzugsweise Regenwasser, bedeckten Oberfläche reflektierten Wellen gemessen werden, wobei aus diesen Meßwerten Betrag und Phase der Reflexionsfaktoren der unbedeckten Oberfläche, z.B. einer trockenen Fahrbahn, ermittelt wird.

7. Meßverfahren durchgeführt mit einer nach den Ansprüchen 5 bis 6 kalibrierten Einrichtung zur Bestimmung von Amplituden- und Phasengrößen zweier unterschiedlich polarisierter von zwei getrennten Empfangsantennen aufgenommener, von mindestens einer Sendeantenne abgestrahlten und an einer zu untersuchenden Oberfläche reflektierte Signale, insbesondere Signale im Mikrowellenbereich, einer reflektometrischen Meßeinrichtung durch Messung der Amplituden der Eingangssignale und der Amplituden von Gemischen der Eingangssignale, die durch Messungen mit direkt aufeinander ausgerichteten Sende- und Empfangsantennen sowohl mit beiden, als auch mit jeweils nur einer an die Empfängerschaltung angeschalteten Empfangsantenne kalibriert wurde, und mit der die komplexen Reflexionsfaktoren der unbedeckten Oberfläche durch Messung der unbedeckten Oberfläche und der mit einer bekannten Schicht bedeckten Oberfläche bestimmt wurden, **dadurch gekennzeichnet**, daß die Beträge der s- und p-polarisierten Anteile der Welle und die Phasendifferenz zwischen den s- und p- polarisierten Anteilen mit Bezug auf die mit einer Schicht bedeckten Oberfläche gemessen und aus diesen Meßwerten unter Berücksichtigung der komplexen Reflexionsfaktoren der unbedeckten Oberfläche sowohl Real- und Imaginärteil der Brech- bzw. Dielektrizitätszahl als auch die Dicke der Schicht ermittelt werden.

## Claims

1. Device for determining amplitude and phase parameters of two signals, especially signals in the microwave range, of a reflectometric measuring device, which signals are differently polarized and are received by two separate receiving antennas and are emitted by at least one transmitting antenna and are reflected at a surface to be investigated, by measuring the amplitudes of the input signals and the amplitudes of mixtures of the input signals, characterized in that the receiving antennas (5, 6) are connected to the inputs of a circuit which exhibits power dividers (9, 10, 11, 12) and power combiners (13, 14) and the four outputs of which are connected to detectors (20, 21, 22, 23), two of which are acted upon directly by the signals of in each case one associated reception antenna (5, 6) and the other two of which are acted upon by a mixture of these signals, one of these latter detectors (21, 22) being acted upon by a mixture of these signals, in which mixture the phase of one of the two signals is shifted.

2. Device according to Claim 1, characterized in that the power dividers (9, 10) connected on the input side to the receiving antennas (5, 6) are connected by one of their outputs to in each case one detector (20, 23) and the second outputs of these power dividers (9, 10) are connected to the inputs of further power dividers (11, 12), one of the outputs of which is connected to an input of in each case one associated power combiner (13, 14) and each of the second outputs of the power dividers (11, 12) is connected to that power combiner (13, 14), the other input of which is connected to the other power divider (11, 12), a phase shifter (15) being disposed in at least one of these lines and the outputs of the power combiners (13, 14) being connected to detectors (21, 22).

3. Device according to Claim 1 or 2, characterized in that attenuators (16, 17, 18, 19) are connected upstream of the detectors (20, 21, 22, 23), which are preferably formed by diodes.

4. Device according to one of Claims 1 to 3, characterized in that the phase shifter (15) inserted between the power divider (12) and the power combiner (13) effects a phase shift of -90°.

5. Process for the calibration of a device for determining amplitude and phase parameters of two signals, especially signals in the microwave range, of a reflectometric measuring device, which signals are differently polarized and are received by two separate receiving antennas and are emitted by at least one transmitting antenna and are reflected at a surface to be investigated, by measuring the amplitudes of the input signals and the amplitudes of mixtures of the input signals, characterized in that, (in a first step) the receiving antennas and the transmitting antenna(s) are aligned directly on top of one another, in that thereafter the amplitude values $A_0$ and $V_0$ - as known per se - are computed in accordance with the following relationship

$$A_0 = B_0 = \frac{\sqrt{D^2 + 4H^2}}{D^2}$$

in which D signifies the spacing between the antennas and H signifies the normal spacing of the receiving antennas from the surface, the reflection of which is intended to be investigated, and in that thereafter measurements are made with in each instance one input, which is terminated in reflection-free fashion, of the power divider connected, in the operational condition, to the antennas, and one measurement is made in the case of which in each instance one of the two antennas is connected to each of the two inputs.

6. Process according to Claim 5, characterized in that, both for the p- polarized and for the s- polarized component of the wave, the antennas (4), (5) and (6) are moved into their final alignment and the magnitudes of the s- polarized and p- polarized components of the wave and the phase difference between the s- polarized and p- polarized components of the waves reflected by the uncovered surface and thereafter the magnitudes of the s- polarized and p- polarized components of the wave and the phase difference between the s- polarized and p- polarized components of the waves reflected by a surface covered with a layer of known refractive index or dielectric constant, preferably rain water, are measured, the magnitude and phase of the reflection factors of the uncovered surface, e.g. of a dry roadway, being determined from these measured values.

7. Measurement process carried out by a device, calibrated according to Claims 5 to 6, for determining amplitude and phase parameters of two signals, especially signals in the microwave range, of a reflectometric measuring device, which signals are differently polarized and are received by two separate receiving antennas and are emitted by at least one transmitting antenna and are reflected at a surface to be investigated, by measuring the amplitudes of the input signals and the amplitudes of mixtures of the input signals, which device has been calibrated by measurements with the transmitting and receiving antennas aligned directly on top of one another both with both and with in each instance only one receiving antenna connected to the receiver circuit, and with which the complex reflection factors of the uncovered surface have been determined by measurement of the uncovered surface and of the surface covered with a known layer, characterized in that the magnitudes of the s-polarized and p-polarized components of the wave and the phase difference between the s- polarized and p-polarized components are measured with respect to the surface covered with a layer, and both the real part and the imaginary part of the refractive index or dielectric constant and the thickness of the layer are determined from these measured values, having regard to the complex reflection factors of the uncovered surface.

## Revendications

1. Dispositif pour la détermination d'amplitudes et de phases de deux signaux, en particulier de signaux hyperfréquence, polarisés différemment reçus par deux antennes réceptrices séparées, émis par au moins une antenne émettrice et réfléchis par une surface à examiner, d'un dispositif réflectométrique par mesure des amplitudes des signaux d'entrée et des amplitudes de mélanges des signaux d'entrée, caractérisé par le fait que les antennes réceptrices (5, 6) sont reliées aux entrées d'un circuit présentant des diviseurs de puissance (9, 10, 11, 12) et des groupeurs de puissance (13, 14) et dont quatre sorties sont reliées à des détecteurs (20, 21, 22, 23) à deux desquels sont appliqués directement les signaux des antennes réceptrices (5, 6) et aux deux autres desquels est appliqué un mélange de ces signaux, à un de ces derniers détecteurs (21, 22) étant appliqué un mélange de ces signaux dans lequel un des deux signaux est déphasé.

2. Dispositif selon la revendication 1, caractérisé par le fait qu'une sortie de chacun des diviseurs de puissance (9, 10), reliés chacun du côté entrée à une antenne réceptrice (5, 6), est reliée à un détecteur (20, 23) et les deuxièmes sorties de ces diviseurs de puissance (9, 10) sont reliées aux entrées d'autres diviseurs de puissance (11, 12) dont une sortie est reliée à une entrée d'un groupeur de puissance associé (13, 14) et la deuxième sortie reliée à celui des groupeurs de puissance (13, 14) dont l'autre entrée est reliée à l'autre des diviseurs de puissance (11, 12), sur au moins une de ces lignes étant monté un déphaseur (15), et les sorties des groupeurs de puissance (13, 14) étant reliées à des détecteurs (21, 22).

3. Dispositif selon l'une des revendications 1 et 2, caractérisé par le fait qu'en amont des détecteurs (20, 21, 22, 23), qui sont de préférence formés de diodes, sont montés des affaiblisseurs (16, 17, 18, 19).

4. Dispositif selon l'une des revendications 1 à 3, caractérisé par le fait que le déphaseur (15) monté entre le diviseur de puissance (12) et le groupeur de puissance (13) produit un déphasage de -90°.

5. Procédé d'étalonnage d'un dispositif pour la détermination d'amplitudes et de phases de deux signaux, en particulier des signaux hyperfréquence, polarisés différemment reçus par deux antennes réceptrices séparées, émis par au moins une antenne émettrice et réfléchis par une surface à examiner, d'un dispositif réflectométrique par mesure des amplitudes des signaux d'entrée et des amplitudes de mélanges des signaux d'entrée, caractérisé par le fait, que dans une première phase, on oriente les antennes réceptrices et l'antenne ou les antennes émettrice(s) directement les unes vers les autres, qu'ensuite on calcule les valeurs d'amplitudes AO et BO, comme connu, par la relation suivante

$$A_O = A_O = \frac{\sqrt{D^2 + 4H^2}}{D^2}$$

où D est la distance entre les antennes et H la distance des antennes réceptrices à la surface dont il s'agit d'examiner la réflexion, et qu'après cela on fait des mesures avec, pour chacune, une entrée sans réflexion du diviseur de puissance relié, à l'état de fonctionnement, aux antennes et une mesure pour laquelle, à chacune des deux entrées, est reliée une des deux antennes.

6. Procédé selon la revendication 5, caractérisé par le fait qu'aussi bien pour la partie polarisée p que pour la partie polarisée s de l'onde, on met les antennes (4, 5 et 6) dans leur orientation finale et mesure les valeurs des parties polarisées s et p de l'onde et la différence de phase entre les parties polarisées s et p des ondes réfléchies par la surface nue et ensuite les valeurs des parties polarisées s et p de l'onde et la différence de phase entre les parties polarisées s et p des ondes réfléchies par une surface couverte d'une couche ayant un indice de réfraction ou une constante diélectrique connue, de préférence d'eau de pluie, et détermine à partir des valeurs mesurées la valeur et la phase des facteurs de réflexion de la surface nue, par exemple d'une chaussée sèche.

7. Procédé de mesure mis en oeuvre avec un dispositif étalonné selon les revendications 5 et 6 pour la détermination d'amplitudes et de phases de deux signaux, en particulier des signaux hyperfréquence, polarisés différemment reçus par deux antennes réceptrices séparées, émis par au moins une antenne émettrice et réfléchis par une surface à examiner, d'un dispositif réflectométrique par mesure des amplitudes des signaux d'entrée et des amplitudes de mélanges des signaux d'entrée, qu'on a étalonné par des mesures avec des antennes émettrices et des antennes réceptrices orientées directement les unes vers les autres avec les deux antennes réceptrices connectées au circuit récepteur et avec une seule antenne réceptrice connectée à ce circuit, et avec lequel on a déterminé les facteurs de réflexion complexes de la surface nue par mesure de celle-ci et de la surface couverte d'une couche connue, caractérisé par le fait qu'on mesure les valeurs des parties polarisées s et p de l'onde et la différence de phase entre les parties polarisées s et p relativement à la surface couverte d'une couche et détermine à partir des valeurs mesurées, en prenant en considération les facteurs de réflexion complexes de la surface nue, la partie réelle et la partie imaginaire de l'indice de réfraction ou de la constante diélectrique et l'épaisseur de la couche.